# EUROPEAN PATENT APPLICATION

(11) **EP 4 135 024 A1**
(43) Date of publication of application: **15.02.2023**
(21) Application number: 21784033.9
(22) Date of filing: 02.04.2021
(51) Int. Cl.: H01L 23/48, H01L 23/495

(54) **TERMINAL CONNECTION STRUCTURE, DISPLAY UNIT, AND DISPLAY**

(30) Priority: 08.04.2020 CN 202010269259
(71) Applicant: Beijing Ivisual 3D Technology Co., Ltd., Beijing 100055 (CN); Visiotech Ventures Pte. Ltd., Singapore 188979 (SG)
(72) Inventor: DIAO, Honghao, Beijing 100055 (CN); HUANG, Lingxi, Singapore 188979 (SG)
(74) Representative: Manitz Finsterwald Patent- und Rechtsanwaltspartnerschaft mbB
(86) International application number: PCT/CN2021/085196
(87) International publication number: WO 2021/204072

(57) **Abstract**

The present application relates to the technical field of optics, and discloses a terminal connection structure, comprising: a plurality of terminals, a plurality of terminal-side conductive holes, an electrical connection layer, and a plurality of light emitting device-side conductive holes, wherein the electrical connection layer is capable of being electrically connected with a plurality of light emitting devices through the plurality of light emitting device-side conductive holes, and electrically connected with a plurality of terminals through the plurality of terminal-side conductive holes; and the plurality of terminals are arranged in array. The plurality of terminal-side conductive holes are arranged by region within a coverage range of the electrical connection layer; and the terminal-side conductive holes arranged in at least one region have a same electric polarity. By the terminal connection structure, terminals for leading wires from light emitting devices may be arranged effectively even if a size of the light emitting device is very small. The present application further discloses a display unit and a display.

## Description

The present application claims priority to the Chinese Patent Application with an application number of 202010269259.1 and a title of "Terminal Connection Structure, Display Unit and Display", filed to China National Intellectual Property Administration on April, 8th, 2020, the disclosures of which are hereby incorporated by reference.

### TECHNICAL FIELD

The present application relates to the technical field of optics, and for example, relates to a terminal connection structure, a display unit and a display.

### BACKGROUND

To control a light emitting device, a terminal for leading a wire from the light emitting device needs to be provided.

In a process of implementing embodiments of the present disclosure, at least the following problems are found in related technologies:
there is no technical solution to arrange terminals for leading wires from light emitting devices when a size of the light emitting device is very small.

### SUMMARY

In order to provide a basic understanding of some aspects of the disclosed embodiments, a brief summary is given below. The summary is not intended to be a general comment, nor to identify key/important components or describe the scope of protection of the embodiments, but to be a preface to the following detailed description.

Embodiments of the present disclosure provide a terminal connection structure, a display unit and a display, to solve a technical problem that a technical solution to provide a terminal for leading a wire from a light emitting device is unavailable.

The terminal connection structure provided by embodiments of the present disclosure includes a plurality of terminals, a plurality of terminal-side conductive holes, an electrical connection layer, and a plurality of light emitting device-side conductive holes, where
the electrical connection layer may be electrically connected with a plurality of light emitting devices through the plurality of light emitting device-side conductive holes, and electrically connected with a plurality of terminals through the plurality of terminal-side conductive holes;
the plurality of terminals are arranged in array;
the plurality of terminal-side conductive holes are arranged by region within a coverage range of the electrical connection layer; and the terminal-side conductive holes arranged in at least one region have a same electric polarity.

In some embodiments, the plurality of terminal-side conductive holes may be divided into at least two regions; and the terminal-side conductive holes arranged in the same region may have a same electric polarity.

In some embodiments, the plurality of terminal-side conductive holes may be divided into three regions, comprising:
a Z-shaped first region, and
a second region and a third region, which are respectively located at two sides of the first region.

In some embodiments, the terminal-side conductive holes arranged in the second region and the third region may have a same electric polarity. Optionally, an electric polarity of the terminal-side conductive holes arranged in the first region may be different from that of the terminal-side conductive holes arranged in the second region and the third region.

In some embodiments, the plurality of terminal-side conductive holes may be divided into four regions in two rows and two columns, comprising:
a first region located in a first column of a first row,
a second region located in a second column of the first row,
a third region located in a first column of a second row, and
a fourth region located in a second column of the second row.

In some embodiments, the terminal-side conductive holes arranged in two adjacent regions of the four regions may have different electric polarities.

In some embodiments, part or all of the terminal-side conductive holes in at least one region may be arranged in array.

In some embodiments, part or all of the terminal-side conductive holes in at least one region may be arranged at equal intervals.

In some embodiments, all of the terminal-side conductive holes arranged by region may fall into part or all of the coverage range of the electrical connection layer.

In some embodiments, the electrical connection layer may include at least two electrical connection layers; and the at least two electrical connection layers are capable of being electrically connected with the plurality of light emitting devices through the plurality of light emitting device-side conductive holes, and electrically connected with the plurality of terminals through the plurality of terminal-side conductive holes.

In some embodiments, the at least two electrical connection layers may include a light emitting device-side electrical connection layer and a terminal-side electrical connection layer; the plurality of light emitting device-side conductive holes may include a plurality of first light emitting device conductive holes and second light emitting device conductive holes.

In some embodiments, the light emitting device-side electrical connection layer is capable of being electrically connected with the plurality of light emitting devices through the plurality of first light emitting device conductive holes. Optionally, the terminal-side electrical connection layer is capable of being electrically connected with the plurality of light emitting devices through the plurality of second light emitting device conductive holes.

In some embodiments, at least one of the plurality of light emitting devices may include a first electrode and a second electrode.

In some embodiments, the light emitting device-side electrical connection layer is capable of being electrically connected with the first electrode through at least one of the plurality of first light emitting device conductive holes. Optionally, the terminal-side electrical connection layer is capable of being electrically connected with the second electrode through at least one of the plurality of second light emitting device conductive holes.

In some embodiments, each of the plurality of light emitting devices may include a first electrode and a second electrode.

In some embodiments, the light emitting device-side electrical connection layer is capable of being electrically connected with the first electrodes of different light emitting devices in the plurality of light emitting devices through the plurality of first light emitting device conductive holes respectively. Optionally, the terminal-side electrical connection layer is capable of being electrically connected with the second electrodes of different light emitting devices in the plurality of light emitting devices through the plurality of second light emitting device conductive holes respectively.

In some embodiments, the terminal-side electrical connection layer and the light emitting device-side electrical connection layer may be sequentially arranged from the plurality of terminals to the plurality of light emitting devices.

In some embodiments, the terminal connection structure may further include at least one of the following insulation layers:
an insulation layer for isolating the plurality of terminals from the terminal-side electrical connection layer;
an insulation layer for isolating the terminal-side electrical connection layer from the light emitting device-side electrical connection layer; and
an insulation layer for isolating the light emitting device-side electrical connection layer from the plurality of light emitting devices.

In some embodiments, the plurality of terminal-side conductive holes may include a plurality of first terminal conductive holes and a plurality of second terminal conductive holes.

In some embodiments, the light emitting device-side electrical connection layer may be electrically connected with the plurality of terminals through the plurality of first terminal conductive holes. Optionally, the terminal-side electrical connection layer may be electrically connected with the plurality of terminals through the plurality of second terminal conductive holes.

In some embodiments, the plurality of terminals may include at least one first terminal and at least one second terminal.

In some embodiments, the light emitting device-side electrical connection layer may be electrically connected with at least one first terminal through at least one of the plurality of first terminal conductive holes. Optionally, the terminal-side electrical connection layer may be electrically connected with at least one second terminal through at least one of the plurality of second terminal conductive holes.

In some embodiments, at least one first terminal may include a plurality of first terminals, and at least one second terminal may include a plurality of second terminals.

In some embodiments, the light emitting device-side electrical connection layer may be electrically connected with the plurality of first terminals respectively through the plurality of first terminal conductive holes. Optionally, the terminal-side electrical connection layer may be electrically connected with the plurality of second terminals through the plurality of second terminal conductive holes respectively.

In some embodiments, the terminal-side conductive holes arranged in the same region may be:
a plurality of first terminal conductive holes, or
a plurality of second terminal conductive holes.

In some embodiments, at least one of the light emitting device-side electrical connection layer and the terminal-side electrical connection layer may be arranged in the following modes:
the light emitting device-side electrical connection layer includes at least one layer of light emitting device-side conductive lines;
the terminal-side electrical connection layer includes at least one layer of terminal-side conductive lines.

In some embodiments, a plurality of terminal-side conductive holes in all regions having a same electric polarity may be electrically connected with a plurality of lines in the same electrical connection layer, respectively.

In some embodiments, all the terminal-side conductive holes having a same electric polarity in all regions may be electrically connected with all lines in the same electrical connection layer, respectively.

In some embodiments, at least one layer of light emitting device-side conductive lines may include a plurality of light emitting device-side conductive lines electrically connected with a plurality of first terminal conductive holes, respectively. Optionally, the terminal-side conductive holes arranged in the same region may be a plurality of first terminal conductive holes.

In some embodiments, the plurality of first terminal conductive holes electrically connected with a plurality of adjacent light emitting device-side conductive lines respectively may be in linear arrangement. Optionally, a plurality of first terminal conductive holes electrically connected with a plurality of spaced light emitting device-side conductive lines may be respectively in linear arrangement. Optionally, a plurality of first terminal conductive holes electrically connected with a plurality of adjacent light emitting device-side conductive lines, and a plurality of first terminal conductive holes electrically connected with a plurality of spaced light emitting device-side conductive lines may be in linear arrangement.

In some embodiments, one light emitting device-side conductive line may be electrically connected with at least one first terminal conductive hole in the plurality of light emitting device-side conductive lines and the plurality of first terminal conductive holes.

In some embodiments, at least one layer of terminal-side conductive lines may include a plurality of terminal-side conductive lines electrically connected with a plurality of second terminal conductive holes, respectively. Optionally, the terminal-side conductive holes arranged in the same region may be a plurality of second terminal conductive holes.

In some embodiments, the plurality of second terminal conductive holes electrically connected with a plurality of adjacent terminal-side conductive lines respectively may be in linear arrangement. Optionally, a plurality of second terminal conductive holes electrically connected with a plurality of spaced terminal-side conductive lines may be in linear arrangement. Optionally, a plurality of second terminal conductive holes electrically connected with a plurality of adjacent terminal-side conductive lines, and a plurality of second terminal conductive holes electrically connected with a plurality of spaced terminal-side conductive lines may be in linear arrangement.

In some embodiments, one terminal-side conductive line may be electrically connected with at least one second terminal conductive hole in the plurality of terminal-side conductive lines and the plurality of second terminal conductive holes.

In some embodiments, the linear arrangement may include oblique line arrangement.

In some embodiments, the linear arrangement may include at least one of straight line arrangement and curved line arrangement.

In some embodiments, the linear arrangement may include the linear arrangement of at least one line.

In some embodiments, at least one of the light emitting device-side conductive lines and the terminal-side conductive lines may be arranged in array.

In some embodiments, at least one of the light emitting device-side conductive lines and the terminal-side conductive lines may be arranged in array in a form of rows or columns.

In some embodiments, the light emitting device-side conductive lines may be arranged in array in a form of rows, and the terminal-side conductive lines may be arranged in array in a form of columns. Optionally, the light emitting device-side conductive lines may be arranged in array in a form of columns; and the terminal-side conductive lines may be arranged in array in a form of rows.

In some embodiments, each of the terminal-side conductive lines may be electrically connected with at least one terminal of the plurality of terminals. Optionally, each of the light emitting device-side conductive lines may be electrically connected with at least one terminal of the plurality of terminals.

In some embodiments, at least one of the plurality of terminals may cover at least one of the plurality of terminal-side conductive holes.

In some embodiments, part or all of the plurality of terminals may be arranged at equal intervals.

In some embodiments, part of the plurality of terminals may be arranged in array. Optionally, all of the plurality of terminals may be arranged in array.

The display unit provided by embodiments of the present disclosure includes a plurality of light emitting devices and the above mentioned terminal connection structure.

In some embodiments, the plurality of light emitting devices may include at least one light emitting diode (LED) light emitting device.

In some embodiments, at least one LED light emitting device may include at least one Micro LED light emitting device.

In some embodiments, the plurality of light emitting devices may be arranged in array.

In some embodiments, part of the plurality of light emitting devices may be arranged in array. Optionally, all of the plurality of light emitting devices may be arranged in array.

The display provided by embodiments of the present disclosure includes the above display unit.

The terminal connection structure, the display unit and the display provided by embodiments of the present disclosure may achieve the following technical effects:
terminals for leading wires from light emitting devices may be arranged effectively even if a size of the light emitting devices is very small.

The above general description and the following description are exemplary and explanatory only, and are not intended to limit the present application.

### DESCRIPTION OF DRAWINGS

One or more embodiments are illustrated by the corresponding drawings, and the illustrations and drawings do not limit the embodiments. Elements having the same reference numerals in the drawings are shown as similar elements, and the drawings are not intended to limit the scale, where:
Figs. 1A, 1B and 1C are structural schematic diagrams of a terminal connection structure provided by embodiments of the present disclosure;
Fig. 2 is a schematic diagram of a principle of arranging terminal-side conductive holes by region provided by embodiments of the present disclosure;
Fig. 3 is another schematic diagram of the principle of arranging the terminal-side conductive holes by region provided by embodiments of the present disclosure;
Fig. 4 is another schematic diagram of the principle of arranging the terminal-side conductive holes by region provided by embodiments of the present disclosure;
Fig. 5 is another structural schematic diagram of the terminal connection structure provided by embodiments of the present disclosure;
Fig. 6 is another structural schematic diagram of the terminal connection structure provided by embodiments of the present disclosure;
Fig. 7 is another structural schematic diagram of the terminal connection structure provided by embodiments of the present disclosure;
Fig. 8 is another structural schematic diagram of the terminal connection structure provided by embodiments of the present disclosure;
Fig. 9 is another structural schematic diagram of the terminal connection structure provided by embodiments of the present disclosure;
Fig. 10 is another structural schematic diagram of the terminal connection structure provided by embodiments of the present disclosure;
Fig. 11 is another structural schematic diagram of the terminal connection structure provided by embodiments of the present disclosure;
Figs. 12A and 12B are structural schematic diagrams of a light emitting device-side electrical connection layer and a terminal-side electrical connection layer provided by embodiments of the present disclosure;
Fig. 13 is a structural schematic diagram of terminal-side conductive holes and lines in a conducting layer provided by embodiments of the present disclosure;
Figs. 14A, 14B, 14C and 14D are structural schematic diagrams of first terminal conductive holes and light emitting device-side conductive lines provided by embodiments of the present disclosure;
Figs. 15A, 15B, 15C and 15D are structural schematic diagrams of second terminal conductive holes and terminal-side conductive lines provided by embodiments of the present disclosure;
Figs. 16A, 16B, 16C and 16D are schematic diagrams of a principle of linear arrangement provided by embodiments of the present disclosure;
Figs. 17 A, 17B, 17 C and 17D are schematic diagrams of arrangements of light emitting device-side conductive lines and terminal-side conductive lines provided by embodiments of the present disclosure;
Fig. 18 is a structural schematic diagram of a display unit provided by embodiments of the present disclosure;
Fig. 19 is another structural schematic diagram of the display unit provided by embodiments of the present disclosure;
Fig. 20 is another structural schematic diagram of the display unit provided by embodiments of the present disclosure;
Fig. 21 is another structural schematic diagram of the display unit provided by embodiments of the present disclosure; and
Figs. 22A and 22B are structural schematic diagrams of a display provided by embodiments of the present disclosure.

### Reference numerals:

110: terminal; 111: first terminal; 112: second terminal; 120: terminal-side conductive hole; 121: first terminal conductive hole; 122: second terminal conductive hole; 130: electrical connection layer; 131: light emitting device-side electrical connection layer; 1311: light emitting device-side conductive line; 132: terminal-side electrical connection layer; 1321: terminal-side conductive line; 140: light emitting device-side conductive hole; 141: first light emitting device conductive hole; 142: second light emitting device conductive hole; 150: light emitting device; Z: region; 151: first electrode; 152: second electrode; 153: LED light emitting device; 154: Micro LED light emitting device; 160: insulation layer; 170: insulation layer; 180: insulation layer; 200: display unit; and 300: display.

### DETAILED DESCRIPTION

To understand features and technical contents of embodiments of the present disclosure in more detail, implementation of the embodiments of the present disclosure is described in detail below with reference to accompanying drawings; and the accompanying drawings are used for reference only, rather than limiting the embodiments of the present disclosure. In following technical description, for the convenience of explanation, a thorough understanding of the disclosed embodiments is provided through more details. However, one or more embodiments may be implemented without the details. In other cases, to simplify the accompanying drawings, well-known structures and apparatuses may be shown simplistically.

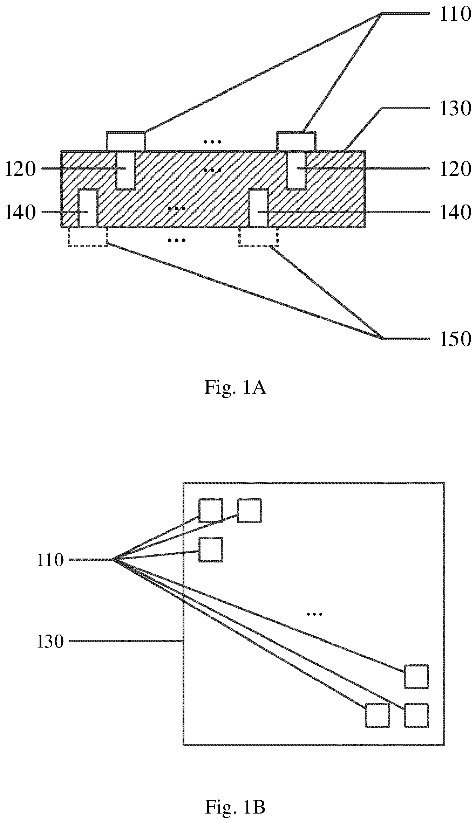

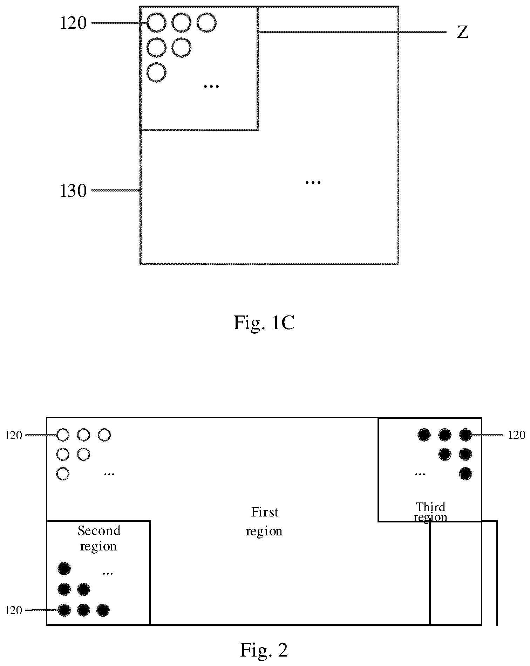

Referring to Figs. 1A, 1B and 1C, embodiments of the present disclosure provide a terminal connection structure, comprising a plurality of terminals 110, a plurality of terminal-side conductive holes 120, an electrical connection layer 130, and a plurality of light emitting device-side conductive holes 140, where
the electrical connection layer 130 may be electrically connected with a plurality of light emitting devices 150 through the plurality of light emitting device-side conductive holes 140, and electrically connected with a plurality of terminals 110 through the plurality of terminal-side conductive holes 120;
the plurality of terminals 110 are arranged in array;
the plurality of terminal-side conductive holes 120 are arranged by region within a coverage range of the electrical connection layer 130; and the terminal-side conductive holes 120 arranged in at least one region have a same electric polarity.

In this way, terminals 110 for leading wires from light emitting devices 150 may be arranged effectively even if a size of the light emitting devices 150 is very small. In addition, the structure is beneficial to flexible and effective arrangement of the terminal connection structure.

In some embodiments, the plurality of terminal-side conductive holes 120 may be divided into at least two regions; and the terminal-side conductive holes 120 arranged in the same region may have a same electric polarity.

Referring to Fig. 2, in some embodiments, the plurality of terminal-side conductive holes 120 may be divided into three regions, comprising: a Z-shaped first region, as well as a second region and a third region, which are respectively located at two sides of the first region.

In some embodiment, the terminal-side conductive holes 120 arranged in the second region and the third region have a same electric polarity; and an electric polarity of the terminal-side conductive holes 120 arranged in the first region is different from that of the terminal-side conductive holes 120 arranged in the second region and the third region. As shown in Fig. 2, all the terminal-side conductive holes 120 represented by circles have a same electric polarity; all the terminal-side conductive holes 120 represented by dots have a same electric polarity; and an electric polarity of the terminal-side conductive holes 120 represented by circles is different from that of the terminal-side conductive holes 120 represented by dots.

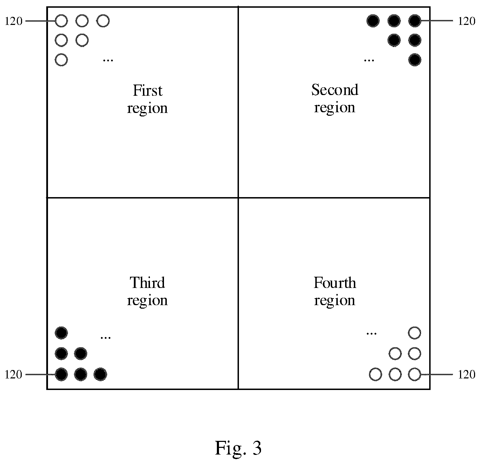

Referring to Fig. 3, in some embodiments, the plurality of terminal-side conductive holes 120 may be divided into four regions in two rows and two columns, comprising a first region located in a first column of a first row, a second region located in a second column of the first row, a third region located in a first column of a second row, and a fourth region located in a second column of the second row.

In some embodiments, the terminal-side conductive holes 120 arranged in two adjacent regions of the four regions have different electric polarities. Optionally, the terminal-side conductive holes 120 arranged in two diagonally opposite regions have a same electric polarity. As shown in Fig. 3, all the terminal-side conductive holes 120 represented by circles have a same electric polarity; all the terminal-side conductive holes 120 represented by dots have a same electric polarity; and an electric polarity of the terminal-side conductive holes 120 represented by circles is different from that of the terminal-side conductive holes 120 represented by dots.

In some embodiments, with reference to Figs. 1C, 2, 3 and 4, part or all of the terminal-side conductive holes 120 in at least one region may be arranged in array. Optionally, whether part or all of the plurality of terminals 120 are arranged in array, an array arrangement mode of the plurality of terminal-side conductive holes 120 may be a matrix, such as a row-and-column mode. In some embodiments, the array arrangement mode of the plurality of terminal-side conductive holes 120 may be different from that shown in Figs. 1C, 2, 3 and 4, but may be array arrangement modes in other array shapes, such as circular, elliptical, triangular and other array arrangement modes. Optionally, the array arrangement mode of the plurality of terminal-side conductive holes 120 is insignificant, as long as the plurality of terminals 110 for leading wires from the light emitting devices 150 **may be effectively arranged**.

In some embodiments, part or all of the terminal-side conductive holes 120 in at least one region may be arranged at equal intervals. Optionally, a distance variation range may be present between part or all of the plurality of terminal-side conductive holes 120, so that positions of part or all of the plurality of terminal-side conductive holes 120 may be flexibly set according to the distance variation range; for example, part of the plurality of terminal-side conductive holes 120 may be arranged at equal intervals while other terminal-side conductive holes 120 may be arranged at unequal intervals, or all of the terminal-side conductive holes 120 may be arranged at unequal intervals.

In some embodiments, as shown in Fig. 1C, all of the terminal-side conductive holes 120 arranged by region may fall into part or all of the coverage range of the electrical connection layer 130.

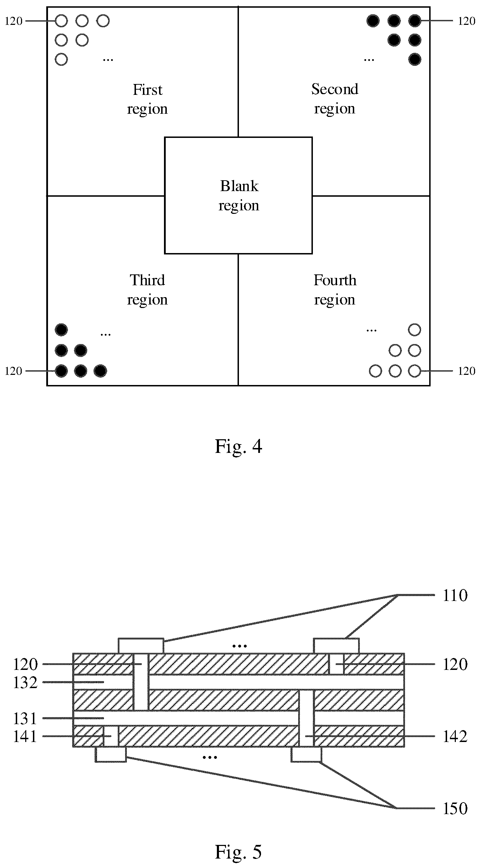

Referring to Fig. 4, in some embodiments, the coverage range of the electrical connection layer 130 (e.g., a longitudinal projection region of the electrical connection layer 130) may include a reserved region, where the terminal-side conductive holes 120 may not be arranged in the reserved region, so as to meet requirements of actual conditions such as process requirements, or provide a space for arrangement of other devices. Optionally, the number of the reserved regions may be one or more; and the coverage range of the reserved region may include, as shown in Fig. 4, part of spaces in the first region, the second region, the third region and the fourth region. Optionally, the coverage range of the reserved region may also be different from that shown in Fig. 4, but include part or all of spaces of part of the divided regions (e.g., at least one region), for example, comprising part of the space in the first region as shown in Fig. 2.

In some embodiments, the electrical connection layer 130 may include at least two electrical connection layers; and the at least two electrical connection layers are capable of being electrically connected with the plurality of light emitting devices 150 through the plurality of light emitting device-side conductive holes 140, and electrically connected with the plurality of terminals 110 through the plurality of terminal-side conductive holes 120.

Referring to Fig. 5, in some embodiments, the at least two electrical connection layers may include a light emitting device-side electrical connection layer 131 and a terminal-side electrical connection layer 132. Optionally, the plurality of light emitting device-side conductive holes 140 may include a plurality of first light emitting device conductive holes 141 and second light emitting device conductive holes 142.

In some embodiments, the light emitting device-side electrical connection layer 131 is capable of being electrically connected with the plurality of light emitting devices 150 through the plurality of first light emitting device conductive holes 141; and the terminal-side electrical connection layer 132 is capable of being electrically connected with the plurality of light emitting devices 150 through the plurality of second light emitting device conductive holes 142.

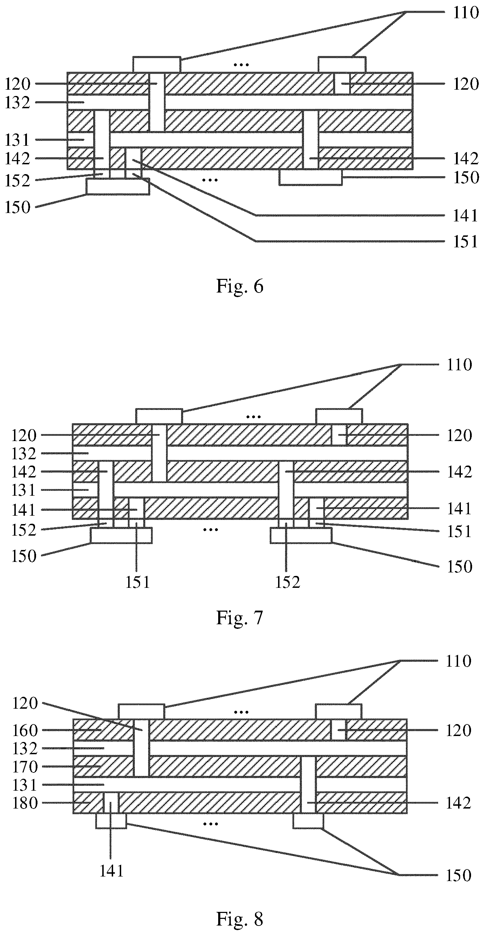

Referring to Fig. 6, in some embodiments, at least one of the plurality of light emitting devices 150 may include a first electrode 151 and a second electrode 152.

In some embodiments, the light emitting device-side electrical connection layer 131 is capable of being electrically connected with the first electrode 151 through at least one of the plurality of first light emitting device conductive holes 141; and the terminal-side electrical connection layer 132 is capable of being electrically connected with the second electrode 152 through at least one of the plurality of second light emitting device conductive holes 142.

Referring to Fig. 7, in some embodiments, at least one of the plurality of light emitting devices 150 may include a first electrode 151 and a second electrode 152.

In some embodiments, the light emitting device-side electrical connection layer 131 is capable of being electrically connected with first electrodes 151 of different light emitting devices 150 of the plurality of light emitting devices 150 through the plurality of first light emitting device conductive holes 141 respectively; and the terminal-side electrical connection layer 132 is capable of being electrically connected with second electrodes 152 of different light emitting devices 150 of the plurality of light emitting devices 150 through the plurality of second light emitting device conductive holes 142.

In some embodiments, the terminal-side electrical connection layer 132 and the light emitting device-side electrical connection layer 131 may be sequentially arranged from the plurality of terminals 110 to the plurality of light emitting devices 150.

Referring to Fig. 8, in some embodiments, the terminal connection structure may further include at least one of the following insulation layers:
an insulation layer 160 for isolating the plurality of terminals 110 from the terminal-side electrical connection layer 132;
an insulation layer 170 for isolating the terminal-side electrical connection layer 132 from the light emitting device-side electrical connection layer 131; and
an insulation layer 180 for isolating the light emitting device-side electrical connection layer 131 from the plurality of light emitting devices 150.

In some embodiments, at least one of the insulation layer 160, the insulation layer 170 and the insulation layer 180 may include at least one layer of insulation structure.

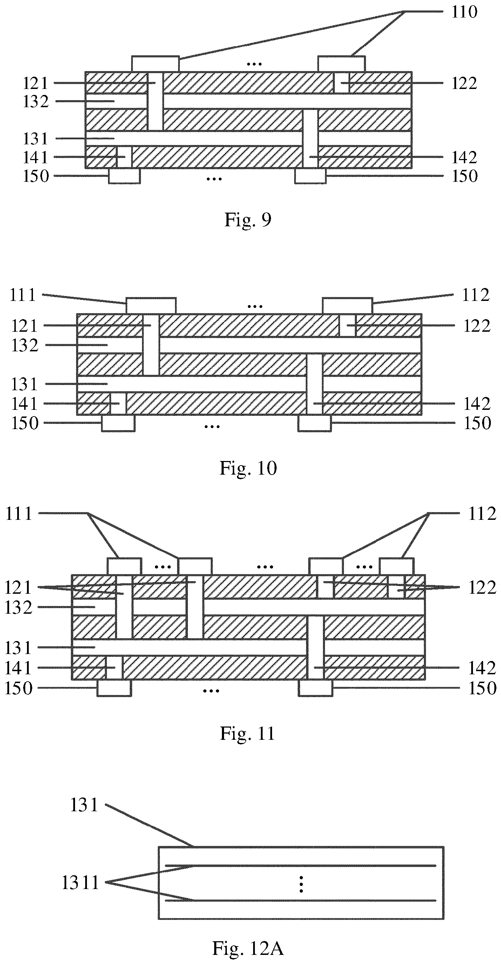

Referring to Fig. 9, in some embodiments, the plurality of terminal-side conductive holes 120 may include a plurality of first terminal conductive holes 121 and a plurality of second terminal conductive holes 122.

In some embodiments, the light emitting device-side electrical connection layer 131 may be electrically connected with the plurality of terminals 110 through the plurality of first terminal conductive holes 121; and the terminal-side electrical connection layer 132 may be electrically connected with the plurality of terminals 110 through the plurality of second terminal conductive holes 122.

Referring to Fig. 10, in some embodiments, the plurality of terminals 110 may include at least one first terminal 111 and at least one second terminal 112.

In some embodiments, the light emitting device-side electrical connection layer 131 may be electrically connected with the at least one first terminal 111 through at least one of the plurality of first terminal conductive holes 121; and the terminal-side electrical connection layer 132 may be electrically connected with the at least one second terminal 112 through at least one of the plurality of second terminal conductive holes 122.

Referring to Fig. 11, in some embodiments, the at least one first terminal 111 may include a plurality of first terminals 111; and at least one second terminal 112 may include a plurality of second terminals 112.

In some embodiments, the light emitting device-side electrical connection layer 131 may be electrically connected with the plurality of first terminals 111 through the plurality of first terminal conductive holes 121 respectively; and the terminal-side electrical connection layer 132 may be electrically connected with the plurality of second terminals 112 through the plurality of second terminal conductive holes 122 respectively.

In some embodiments, the plurality of terminal-side conductive holes 120 arranged in the same region may be the plurality of first terminal conductive holes 121 or the plurality of second terminal conductive holes 122.

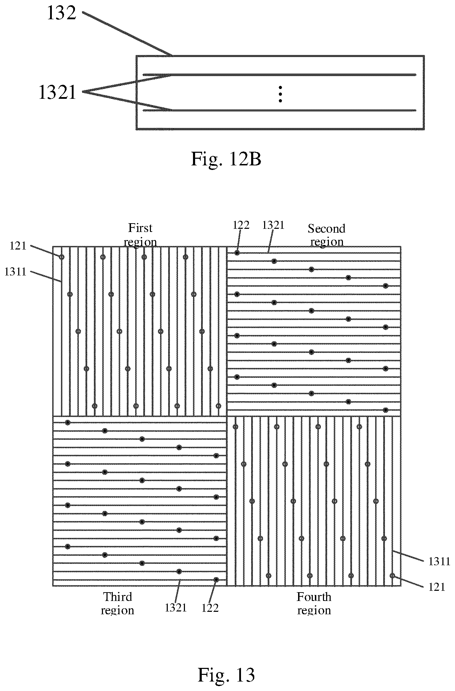

Referring to Figs. 12A and 12B, in some embodiments, at least one of the light emitting device-side electrical connection layer 131 and the terminal-side electrical connection layer 132 may be arranged in the following modes:
the light emitting device-side electrical connection layer 131 includes at least one layer of light emitting device-side conductive lines 1311;
the terminal-side electrical connection layer 132 includes at least one layer of terminal-side conductive lines 1321.

In Fig. 12A, the light emitting device-side conductive lines 1311 of different layers are exemplified from top to bottom in the light emitting device-side electrical connection layer 131. Optionally, each wire segment in the light emitting device-side electrical connection layer 131 represents a layer of light emitting device-side conductive lines 1311.

In Fig. 12B, the terminal-side conductive lines 1321 of different layers are exemplified from top to bottom in the terminal-side electrical connection layer 132. Optionally, each wire segment in the terminal-side electrical connection layer 132 represents a layer of terminal-side conductive lines 1321.

Referring to Fig. 13, in some embodiments, a plurality of terminal-side conductive holes 120 in all regions having a same electric polarity may be electrically connected with a plurality of lines in the same electrical connection layer 130, respectively.

In some embodiments, all the terminal-side conductive holes 120 having a same electric polarity in all regions may be electrically connected with all lines in the same electrical connection layer 130, respectively.

In some embodiments, as shown in Fig. 13, the plurality of terminal-side conductive holes 120 may be divided into four regions in two rows and two columns, comprising a first region located in a first column of a first row, a second region located in a second column of the first row, a third region located in a first column of a second row, and a fourth region located in a second column of the second row. Optionally, a plurality of first terminal conductive holes 121 electrically connected with the plurality of light emitting device-side conductive lines 1311 may be arranged in the first region; and the plurality of light emitting device-side conductive lines 1311 in the first region may be arranged in column lines, row lines or other modes. Optionally, a plurality of second terminal conductive holes 122 electrically connected with the plurality of terminal-side conductive lines 1321 may be arranged in the second region; and the plurality of terminal-side conductive lines 1321 in the second region may be arranged in row lines, column lines or other modes. Optionally, a plurality of second terminal conductive holes 122 electrically connected with the plurality of terminal-side conductive lines 1321 may be arranged in the third region; and the plurality of terminal-side conductive lines 1321 in the third region may be arranged in row lines, column lines or other modes. Optionally, a plurality of first terminal conductive holes 121 electrically connected with the plurality of light emitting device-side conductive lines 1311 may be arranged in the fourth region; and the plurality of light emitting device-side conductive lines 1311 in the fourth region may be arranged in column lines, row lines or other modes. As shown in Fig. 13, all the first terminal conductive holes 121 represented by circles have a same electric polarity; all the second terminal conductive holes 122 represented by dots have a same electric polarity; and an electric polarity of the first terminal conductive holes 121 represented by circles is different from that of the second terminal conductive holes 122 represented by dots. Based on the above arrangement modes, in the above four regions, the terminal-side conductive holes 120 arranged in two adjacent regions have different electric polarities, while the terminal-side conductive holes 120 arranged in two diagonally opposite regions have a same electric polarity, i.e., a plurality of first terminal conductive holes 121 having a same electric polarity are arranged in the first region and the fourth region, and a plurality of second terminal conductive holes 122 having a same electric polarity are arranged in the second region and third region.

In some embodiments, different from that shown in Fig. 13, the plurality of terminal-side conductive holes 120 may be divided into three regions as shown in Fig. 2, comprising: a Z-shaped first region, as well as a second region and a third region, which are respectively located at two sides of the first region. Optionally, the terminal-side conductive holes 120 arranged in the first region may be a plurality of first terminal conductive holes 121 electrically connected with the plurality of light emitting device-side conductive lines 1311; and the plurality of light emitting device-side conductive lines 1311 in the first region may be arranged in column lines, row lines or other modes. Optionally, a plurality of second terminal conductive holes 122 electrically connected with the plurality of terminal-side conductive lines 1321 may be arranged in the second region; and the plurality of terminal-side conductive lines 1321 in the second region may be arranged in row lines, column lines or other modes. Optionally, a plurality of second terminal conductive holes 122 electrically connected with the plurality of terminal-side conductive lines 1321 may be arranged in the third region; and the plurality of terminal-side conductive lines 1321 in the third region may be arranged in row lines, column lines or other modes. Optionally, an electric polarity of the first terminal conductive holes 121 is different from that of the second terminal conductive holes 122. Based on the above arrangement modes, in the above three regions, a plurality of second terminal conductive holes 122 having a same electric polarity are arranged in the second region and the third region; and an electric polarity of the first terminal conductive holes 121 arranged in the first region is different from that of the second terminal conductive holes 122 arranged in the second region and the third region.

In some embodiments, the regions may be arranged according to actual conditions such as process requirements, for example, setting the number, positions, shapes and the like of the regions. Optionally, the terminal-side conductive holes 120 with a specific electric polarity may also be arranged according to actual conditions such as process requirements; for example, a plurality of first terminal conductive holes 121 electrically connected with the light emitting device-side conductive lines 1311 may be arranged in a certain region, and a plurality of second terminal conductive holes 122 electrically connected with the terminal-side conductive lines 1321 may also be arranged in a certain region. How the regions and the terminal-side conductive holes 120 in the regions are arranged is insignificant, as long as a normal connection between the terminal-side conductive holes 120 and the corresponding conductive lines (such as the light emitting device-side conductive lines 1311 and the terminal-side conductive lines 1321) may be realized, so as to effectively arrange a plurality of terminals 110 for leading wires from the light emitting devices 150.

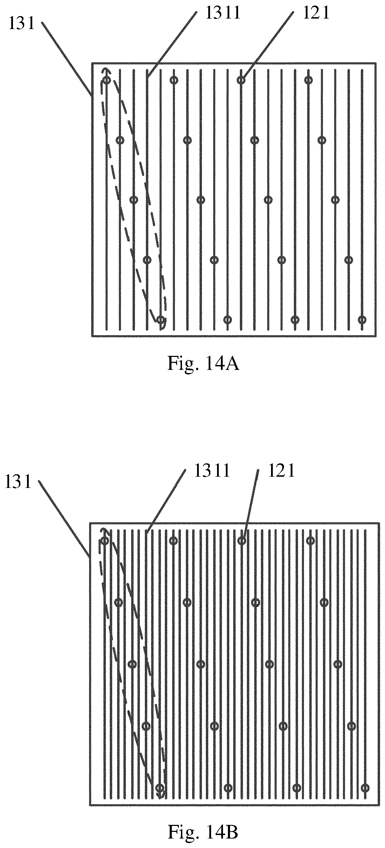

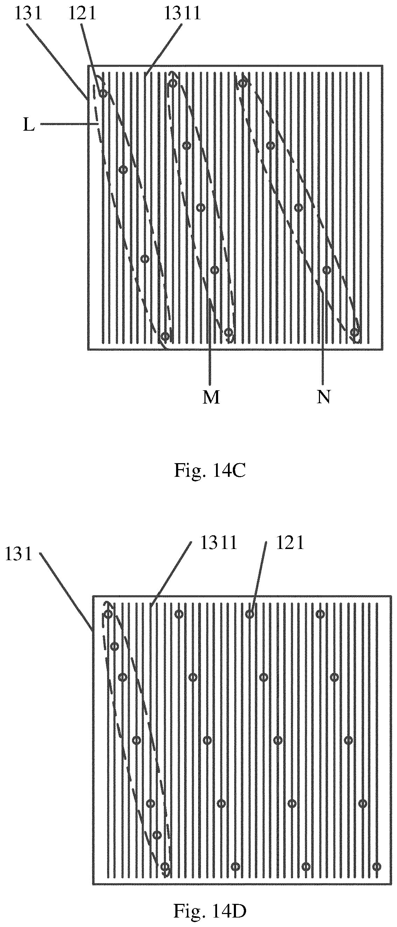

Referring to Figs. 14A, 14B, 14C and 14D, in some embodiments, at least one layer of light emitting device-side conductive lines 1311 may include a plurality of light emitting device-side conductive lines 1311 electrically connected with a plurality of first terminal conductive holes 121, respectively. Optionally, the terminal-side conductive holes 120 arranged in the same region may be the plurality of first terminal conductive holes 121.

In some embodiments, as shown in Fig. 14A, the plurality of first terminal conductive holes 121 electrically connected with a plurality of adjacent light emitting device-side conductive lines 1311 respectively may be in linear arrangement. For example, the plurality of first terminal conductive holes 121 included in a dashed box may be in linear arrangement. Optionally, as shown in Fig. 14A, a plurality of first terminal conductive holes 121 outside the dashed box may be in linear arrangement in a plurality of lines.

In some embodiments, as shown in Figs. 14B and 14C, the plurality of first terminal conductive holes 121 electrically connected with a plurality of spaced light emitting device-side conductive lines 1311 respectively may be in linear arrangement.

In some embodiments, as shown in Fig. 14B, the plurality of first terminal conductive holes 121 included in the dashed box may be in linear arrangement; optionally, one light emitting device-side conductive line 1311 is spaced between every two adjacent light emitting device-side conductive lines 1311 of the plurality of light emitting device-side conductive lines 1311 connected with the plurality of first terminal conductive holes 121 included in the dashed box. Optionally, as shown in Fig. 14B, the plurality of first terminal conductive holes 121 outside the dashed box may be in linear arrangement in a plurality of lines.

In some embodiments, as shown in Fig. 14C, the number of light emitting device-side conductive lines 1311 spaced between every two adjacent light emitting device-side conductive lines 1311 of the plurality of light emitting device-side conductive lines 1311 connected with the plurality of first terminal conductive holes 121 may be different, such as one, two or three.

In some embodiments, as shown in Fig. 14C, the plurality of first terminal conductive holes 121 included in a dashed box M may be in linear arrangement; optionally, one light emitting device-side conductive line 1311 is spaced between every two adjacent light emitting device-side conductive lines 1311 of the plurality of light emitting device-side conductive lines 1311 connected with the plurality of first terminal conductive holes 121 included in the dashed box M.

In some embodiments, as shown in Fig. 14C, the plurality of first terminal conductive holes 121 included in a dashed box L may be in linear arrangement; optionally, two light emitting device-side conductive lines 1311 are spaced between every two adjacent light emitting device-side conductive lines 1311 of the plurality of light emitting device-side conductive lines 1311 connected with the plurality of first terminal conductive holes 121 included in the dashed box L.

In some embodiments, as shown in Fig. 14C, the plurality of first terminal conductive holes 121 included in a dashed box N may be in linear arrangement; optionally, three light emitting device-side conductive lines 1311 are spaced between every two adjacent light emitting device-side conductive lines 1311 of the plurality of light emitting device-side conductive lines 1311 connected with the plurality of first terminal conductive holes 121 included in the dashed box N.

In some embodiments, the number of the light emitting device-side conductive lines 1311 spaced between two adjacent light emitting device-side conductive lines 1311 of the plurality of light emitting device-side conductive lines 1311 connected with the plurality of first terminal conductive holes 121 may be the same or different, whether in the same dashed box or not.

In some embodiments, as shown in Fig. 14D, a plurality of first terminal conductive holes 121 electrically connected with a plurality of adjacent light emitting device-side conductive lines 1311, and a plurality of first terminal conductive holes 121 electrically connected with a plurality of spaced light emitting device-side conductive lines 1311 may be in linear arrangement.

In some embodiments, as shown in Fig. 14D, all the first terminal conductive holes 121 in the dashed box include: the plurality of first terminal conductive holes 121 electrically connected with the plurality of adjacent light emitting device-side conductive lines 1311, and the plurality of first terminal conductive holes 121 electrically connected with the plurality of spaced light emitting device-side conductive lines 1311; and all the first terminal conductive holes 121 may be in linear arrangement. Optionally, two different adjacent light emitting device-side conductive lines 1311 of the plurality of light emitting device-side conductive lines 1311 connected with the plurality of first terminal conductive holes 121 may not be spaced, whether in the same dashed box or not, by the light emitting device-side conductive line 1311, and may also be spaced by the light emitting device-side conductive line 1311; and the number of the spaced light emitting device-side conductive lines 1311 may be the same or different.

In some embodiments, the linear arrangement of the plurality of first terminal conductive holes 121 and the electrical connection relationship between the plurality of first terminal conductive holes 121 and the plurality of light emitting device-side conductive lines 1311 may be set according to actual conditions such as process requirements, as long as the normal connection between the first terminal conductive holes 121 and the light emitting device-side conductive lines 1311 may be realized, so as to effectively arrange the plurality of terminals 110 for leading the wires from the light emitting devices 150.

In some embodiments, as shown in Figs. 14A, 14B, 14C and 14D, one light emitting device-side conductive line 1311 may be electrically connected with at least one first terminal conductive hole 121 in the plurality of light emitting device-side conductive lines 1311 and the plurality of first terminal conductive holes 121. Optionally, one light emitting device-side conductive line 1311 may be electrically connected with one first terminal conductive hole 121 in the plurality of light emitting device-side conductive lines 1311 and the plurality of first terminal conductive holes 121. Optionally, one light emitting device-side conductive line 1311 may be electrically connected with at least two first terminal conductive holes 121 in the plurality of light emitting device-side conductive lines 1311 and the plurality of first terminal conductive holes 121, so as to provide a backup of the electrical connection between the first terminal conductive holes 121 and the light emitting device-side conductive lines 1311.

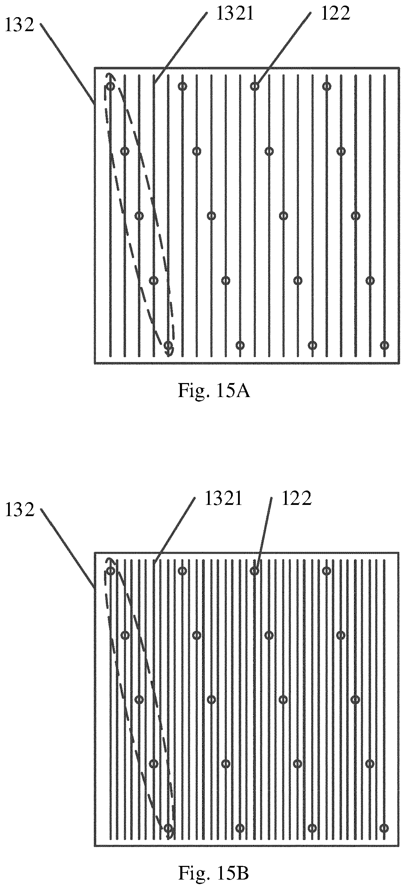

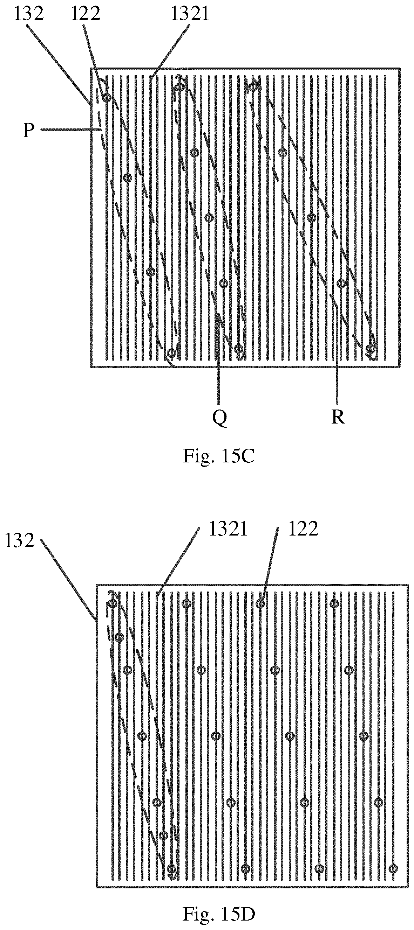

Referring to Figs. 15A, 15B, 15C and 15D, in some embodiments, at least one layer of terminal-side conductive lines 1321 may include a plurality of terminal-side conductive lines 1321 electrically connected with a plurality of second terminal conductive holes 122, respectively. Optionally, the terminal-side conductive holes 120 arranged in the same region may be the plurality of second terminal conductive holes 122.

In some embodiments, as shown in Fig. 15A, the plurality of second terminal conductive holes 122 electrically connected with a plurality of adjacent terminal-side conductive lines 1321 respectively may be in linear arrangement. For example, the plurality of second terminal conductive holes 122 included in a dashed box may be in linear arrangement. Optionally, as shown in Fig. 15A, a plurality of second terminal conductive holes 122 outside the dashed box may be in linear arrangement in a plurality of lines.

In some embodiments, as shown in Fig. 15B and 15C, the plurality of second terminal conductive holes 122 electrically connected with a plurality of spaced terminal-side conductive lines 1321 respectively may be in linear arrangement.

In some embodiments, as shown in Fig. 15B, the plurality of second terminal conductive holes 122 included in the dashed box may be in linear arrangement; optionally, one terminal-side conductive line 1321 is spaced between every two adjacent terminal-side conductive lines 1321 of the plurality of terminal-side conductive lines 1321 connected with the plurality of second terminal conductive holes 122 included in the dashed box. Optionally, as shown in Fig. 15B, a plurality of second terminal conductive holes 122 outside the dashed box may be in linear arrangement in a plurality of lines.

In some embodiments, as shown in Fig. 15C, the number of terminal-side conductive lines 1321 spaced between every two adjacent terminal-side conductive lines 1321 of the plurality of terminal-side conductive lines 1321 connected with the plurality of second terminal conductive holes 122 may be different, such as one, two or three.

In some embodiments, as shown in Fig. 15C, the plurality of second terminal conductive holes 122 included in a dashed box Q may be in linear arrangement; optionally, one terminal-side conductive line 1321 is spaced between every two adjacent terminal-side conductive lines 1321 of the plurality of terminal-side conductive lines 1321 connected with the plurality of second terminal conductive holes 122 included in the dashed box Q.

In some embodiments, as shown in Fig. 15C, the plurality of second terminal conductive holes 122 included in a dashed box P may be in linear arrangement; optionally, two terminal-side conductive lines 1321 are spaced between every two adjacent terminal-side conductive lines 1321 of the plurality of terminal-side conductive lines 1321 connected with the plurality of second terminal conductive holes 122 included in the dashed box P.

In some embodiments, as shown in Fig. 15C, the plurality of second terminal conductive holes 122 included in a dashed box R may be in linear arrangement; optionally, three terminal-side conductive lines 1321 are spaced between every two adjacent terminal-side conductive lines 1321 of the plurality of terminal-side conductive lines 1321 connected with the plurality of second terminal conductive holes 122 included in the dashed box R.

In some embodiments, the number of the terminal-side conductive lines 1321 spaced between two adjacent terminal-side conductive lines 1321 of the plurality of terminal-side conductive lines 1321 connected with the plurality of second terminal conductive holes 122 may be the same or different, whether in the same dashed box or not.

In some embodiments, as shown in Fig. 15D, a plurality of second terminal conductive holes 122 electrically connected with a plurality of terminal-side conductive lines 1321, and a plurality of second terminal conductive holes 122 electrically connected with a plurality of spaced terminal-side conductive lines 1321 may be in linear arrangement.

In some embodiments, as shown in Fig. 15D, all the second terminal conductive holes 122 in the dashed box include: the plurality of second terminal conductive holes 122 electrically connected with the plurality of adjacent terminal-side conductive lines 1321, and the plurality of second terminal conductive holes 122 electrically connected with the plurality of spaced terminal-side conductive lines 1321; and all the second terminal conductive holes 122 may be in linear arrangement. Optionally, two different adjacent terminal-side conductive lines 1321 of the plurality of terminal-side conductive lines 1321 connected with the plurality of second terminal conductive holes 122 may not be spaced, whether in the same dashed box or not, by the terminal-side conductive line 1321, and may also be spaced by the terminal-side conductive line 1321; and the number of the spaced terminal-side conductive lines 1321 may be the same or different.

In some embodiments, the linear arrangement of the plurality of second terminal conductive holes 122 and the electrical connection relationship between the plurality of second terminal conductive holes 122 and the plurality of terminal-side conductive lines 1321 may be set according to actual conditions such as process requirements, as long as the normal connection between the second terminal conductive holes 122 and the terminal-side conductive lines 1321 may be realized, so as to effectively arrange the plurality of terminals 110 for leading the wires from the light emitting devices 150.

In some embodiments, as shown in Figs. 15A, 15B, 15C and 15D, one terminal-side conductive line 1321 may be electrically connected with at least one second terminal conductive hole 122 in the plurality of terminal-side conductive lines 1321 and the plurality of second terminal conductive holes 122. Optionally, one terminal-side conductive line 1321 may be electrically connected with one second terminal conductive hole 122 in the plurality of terminal-side conductive lines 1321 and the plurality of second terminal conductive holes 122. Optionally, one terminal-side conductive line 1321 may be electrically connected with at least two second terminal conductive holes 122 in the plurality of terminal-side conductive lines 1321 and the plurality of second terminal conductive holes 122, so as to provide a backup of the electrical connection between the second terminal conductive holes 122 and the terminal-side conductive lines 1321.

Referring to Figs. 14A, 14B, 14C, 14D, 15A, 15B, 15C and 15D, in some embodiments, the linear arrangement may include oblique line arrangement, for example, the linear arrangement presented in each dashed box may be the oblique line arrangement. Optionally, different linear arrangements may include oblique line arrangements with the same or different slopes.

In some embodiments, the linear arrangements with different angles may be set according to actual conditions such as process requirements; for example, the linear arrangements may include horizontal line arrangement, oblique line arrangement, vertical line arrangement and the like.

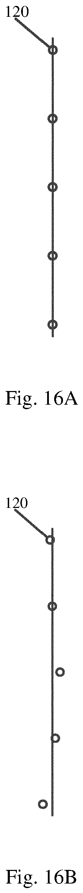

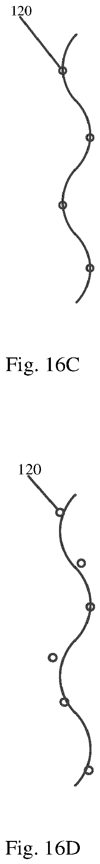

Referring to Figs. 16A, 16B, 16C and 16D, in some embodiments, the linear arrangements may include at least one of straight line arrangement and curved line arrangement.

In some embodiments, the linear arrangements may include the straight line arrangement. Optionally, as shown in Fig. 16A, all the terminal-side conductive holes 120 are located on a straight line to form the straight line arrangement. Optionally, as shown in Fig. 16B, part of all the terminal-side conductive holes 120 are located on a straight line, and other terminal-side conductive holes 120 have a certain distance from the straight line (e.g., a shortest distance between the terminal-side conductive holes 120 and the straight line); when the distance does not exceed a distance threshold, all the terminal-side conductive holes 120 shown in Fig. 16B may be considered to be in a linear arrangement, for example, in the straight line arrangement. Optionally, the distance threshold may be set according to actual conditions such as process requirements; for example, the distance threshold is set to be a radius of the terminal-side conductive hole 120, a multiple of the radius, or the like.

In some embodiments, the linear arrangements may include the curved line arrangement. Optionally, as shown in Fig. 16C, all the terminal-side conductive holes 120 are located on a curved line to form the curved line arrangement. Optionally, as shown in Fig. 16D, part of all the terminal-side conductive holes 120 are located on a curved line, and other terminal-side conductive holes 120 have a certain distance from the curved line (e.g., a shortest distance between the terminal-side conductive holes 120 and the curved line); when the distance does not exceed a distance threshold, all the terminal-side conductive holes 120 shown in Fig. 16D may be considered to be in a linear arrangement, for example, in the curved line arrangement. Optionally, the distance threshold may be set according to actual conditions such as process requirements; for example, the distance threshold is set to be a radius of the terminal-side conductive hole 120, a multiple of the radius, or the like.

In some embodiments, the distance threshold as well as a curvature and shape of the above curve may be set according to actual conditions such as process requirements, as long as the normal connection between the terminal-side conductive holes 120 and the corresponding conductive lines (such as the light emitting device-side conductive lines 1311 and the terminal-side conductive lines 1321) may be realized, so as to effectively arrange the plurality of terminals 110 for leading the wires from the light emitting devices 150.

Referring to Figs. 14A, 14B, 14C, 14D, 15A, 15B, 15C and 15D, in some embodiments, the linear arrangement may include the linear arrangement of at least one line, for example, the linear arrangement of one line included in any dashed box. Optionally, the linear arrangements may include a linear arrangement of two or more lines, such as a linear arrangement of three lines outside the dashed box in Figs. 14A, 14B, 14D, 15A, 15B and 15D, and a linear arrangement of three lines in the dashed box in Figs. 14C and 15C.

In some embodiments, the number of lines included in the linear arrangement may be set according to actual conditions such as process requirements, as long as the normal connection between the terminal-side conductive holes 120 and the corresponding conductive lines (such as the light emitting device-side conductive lines 1311 and the terminal-side conductive lines 1321) may be realized, so as to effectively arrange the plurality of terminals 110 for leading the wires from the light emitting devices 150.

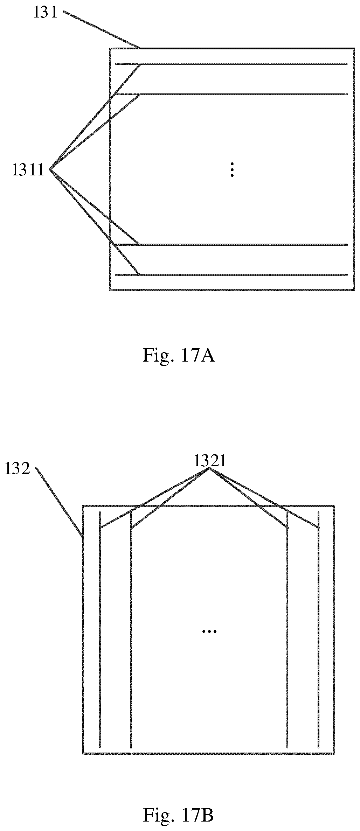

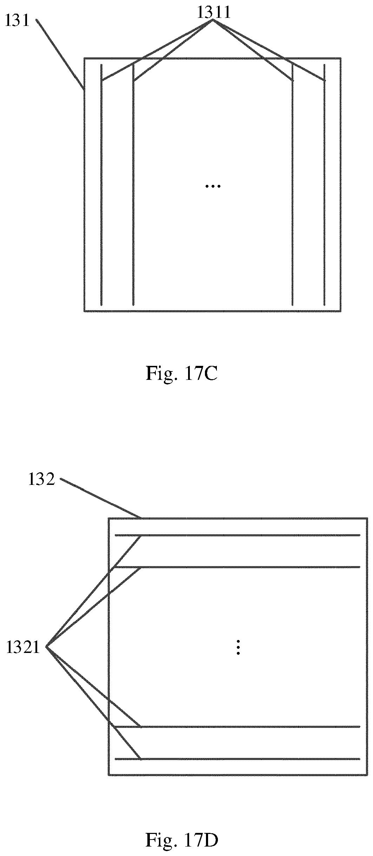

Referring to Figs. 17A, 17B, 17C and 17D, in some embodiments, at least one of the light emitting device-side conductive lines 1311 and the terminal-side conductive lines 1321 may be arranged in array.

In some embodiments, at least one of the light emitting device-side conductive lines 1311 and the terminal-side conductive lines 1321 may be arranged in array in a form of rows or columns.

As shown in Figs. 17A and 17B, in some embodiments, the light emitting device-side conductive lines 1311 may be arranged in array in a form of rows; and the terminal-side conductive lines 1321 may be arranged in array in a form of columns. As shown in Figs. 17C and 17D, in some embodiments, the light emitting device-side conductive lines 1311 may be arranged in array in a form of columns; and the terminal-side conductive lines 1321 may be arranged in array in a form of rows.

As shown in Figs. 17A, 17B, 17C and 17D, an array arrangement mode of the light emitting device-side conductive lines 1311 and the terminal-side conductive lines 1321 may be a row-and-column mode. In some embodiments, the array arrangement mode of the light emitting device-side conductive lines 1311 and the terminal-side conductive lines 1321 may be different from that shown in Fig. 1B, but may be arrangement modes in other array shapes, such as circular, elliptical, triangular and other array arrangement modes. Optionally, the array arrangement mode of the light emitting device-side conductive lines 1311 and the terminal-side conductive lines 1321 is insignificant, as long as the plurality of terminals 110 for leading wires from the light emitting devices 150 **may be effectively arranged**.

In some embodiments, each of the terminal-side conductive lines 1321 may be electrically connected with at least one terminal 110 of the plurality of terminals 110. Optionally, each of the light emitting device-side conductive lines 1311 may be electrically connected with at least one terminal 110 of the plurality of terminals 110.

In some embodiments, each of the terminal-side conductive lines 1321 may be electrically connected with one second terminal 112 of the plurality of second terminals 112, so that different lines of the terminal-side conductive lines 1321 are electrically connected with different second terminals 112 of the plurality of second terminals 112, respectively. Optionally, each of the terminal-side conductive lines 1321 may be electrically connected with at least two second terminals 112 of the plurality of second terminals 112, to provide a backup of electrical connection between the second terminals 112 and the terminal-side conductive lines 1321.

In some embodiments, each of the light emitting device-side conductive lines 1311 may be electrically connected with one first terminal 111 of the plurality of first terminals 111, so that different lines of the light emitting device-side conductive lines 1311 are electrically connected with different first terminals 111 of the plurality of first terminals 111, respectively. Optionally, each of the light emitting device-side conductive lines 1311 may be electrically connected with at least two first terminals 111 of the plurality of first terminals 111, to provide a backup of electrical connection between the first terminals 111 and the light emitting device-side conductive lines 1311.

Referring to Fig. 5, in some embodiments, at least one terminal 110 of the plurality of terminals 110 may cover at least one terminal-side conductive hole 120 of the plurality of terminal-side conductive holes 120, for example, at least one terminal 110 of the plurality of terminals 110 may cover at least one terminal-side conductive hole 120, with which the terminal 110 is electrically connected, of the plurality of terminal-side conductive holes 120.

In some embodiments, at least one terminal 110 of the plurality of terminals 110 may cover part or all of at least one terminal-side conductive hole 120 of the plurality of terminal-side conductive holes 120, for example, at least one terminal 110 of the plurality of terminals 110 may cover part or all of at least one terminal-side conductive hole 120, with which the terminal 110 is electrically connected, of the plurality of terminal-side conductive holes 120. Optionally, at least one terminal 110 of the plurality of terminals 110 may not cover at least one terminal-side conductive hole 120, with which the terminal 110 is electrically connected, of the plurality of terminal-side conductive holes 120. Optionally, whether the terminal 110 covers the terminal-side conductive hole 120 or whether the terminal 110 covers part or all of the terminal-side conductive hole 120, as long as the electrical connection between the terminals 110 and the terminal-side conductive holes 120 may be effectively realized, to effectively arrange the plurality of terminals 110 for leading wires from the light emitting devices 150.

Referring to Fig. 1B, in some embodiments, some or all of the plurality of terminals 110 may be arranged at equal intervals. Optionally, a distance variation range may be present between part or all of the plurality of terminals 110, so that positions of part or all of the plurality of terminals 110 may be flexibly set according to the distance variation range; for example, part of the plurality of terminals 110 may be arranged at equal intervals while other terminals 110 may be arranged at unequal intervals, or all of the terminals 110 may be arranged at unequal intervals.

Referring to Fig. 1B, in some embodiments, part of the plurality of terminals 110 may be arranged in array. Optionally, all of the plurality of terminals 110 may be arranged in array.

As shown in Fig. 1B, whether part or all of the plurality of terminals 110 are arranged in array, an array arrangement mode of the plurality of terminals 110 may be a matrix, such as a row-and-column mode. In some embodiments, the array arrangement mode of the plurality of terminals 110 may be different from that shown in Fig. 1B, but may be array arrangement modes in other array shapes, such as circular, elliptical, triangular and other array arrangement modes. Optionally, the array arrangement mode of the plurality of terminals 110 is insignificant, as long as the plurality of terminals 110 for leading wires from the light emitting devices 150 **may be effectively arranged**.

In some embodiments, shapes of part or all of the plurality of terminals 110 may be the same or different. Optionally, since thicknesses of the terminals 110 are usually very small, the shapes of the terminals 110 may refer to shapes of the surfaces of the terminals 110. Optionally, the shape of at least one terminal 110 of the plurality of terminals 110 may be rectangular, circular, spherical and other shapes; and other shapes such as polygonal and abnormal shapes may also be set according to actual conditions such as process requirements.

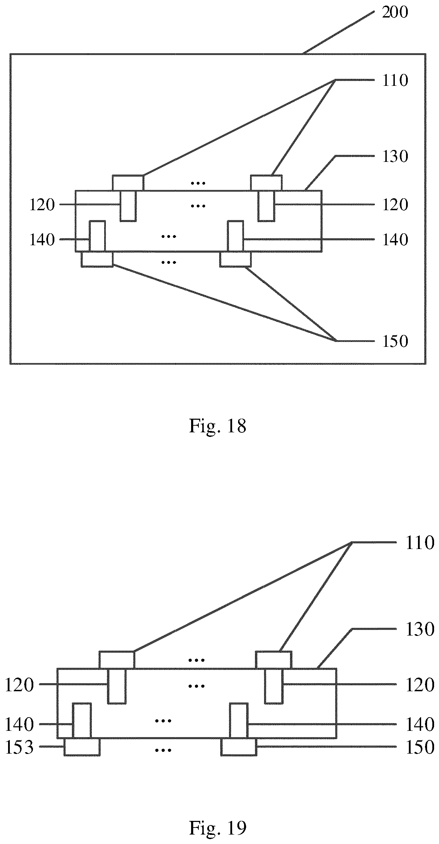

Referring to Fig. 18, embodiments of the present disclosure provide a display unit 200, comprising a plurality of light emitting devices 150, and the above mentioned terminal connection structure.

Referring to Fig. 19, in some embodiments, the plurality of light emitting devices 150 may include at least one LED light emitting device 153; for example, part or all of the plurality of light emitting devices 150 may be LED light emitting devices 153.

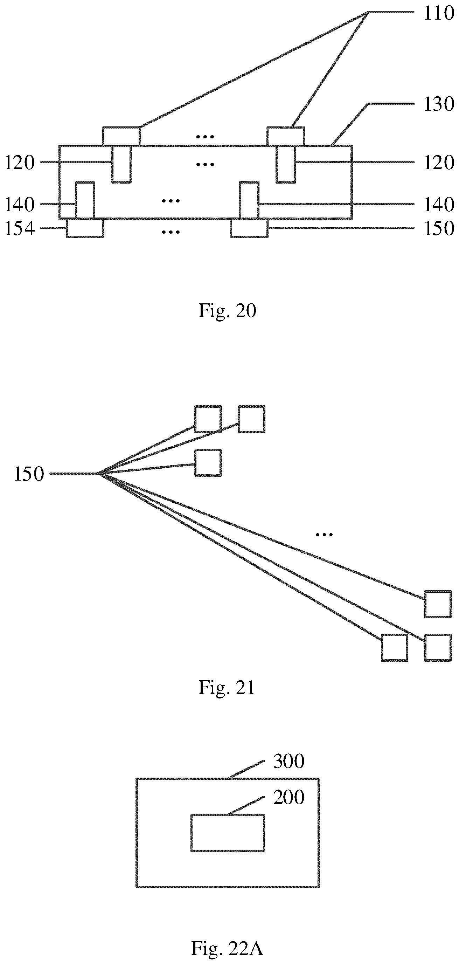

Referring to Fig. 20, in some embodiments, at least one LED light emitting device 153 may include at least one Micro LED light emitting device 154; for example, part or all of the plurality of light emitting devices 150 may be the Micro LED light emitting device 154. Optionally, at least one LED light emitting device 153 may include at least one Mini LED light emitting device; for example, part or all of the plurality of light emitting devices 150 may be the Mini LED light emitting device.

Referring to Fig. 21, in some embodiments, the plurality of light emitting devices 150 may be arranged in array.

In some embodiments, part of the plurality of light emitting devices 150 may be arranged in array. Optionally, all of the plurality of light emitting devices 150 may be arranged in array.

As shown in Fig. 21, whether part or all of the plurality of light emitting devices 150 are arranged in array, an array arrangement mode of the plurality of light emitting devices 150 may be a matrix, such as a row-and-column mode. In some embodiments, the array arrangement mode of the plurality of light emitting devices 150 may be different from that shown in Fig. 21, but may be array arrangement modes in other array shapes, such as circular, elliptical, triangular and other array arrangement modes. Optionally, the array arrangement mode of the plurality of light emitting devices 150 is insignificant, as long as the plurality of terminals 110 for leading wires from the light emitting devices 150 **may be effectively arranged**.

In some embodiments, shapes of part or all of the plurality of light emitting devices 150 may be the same or different. Optionally, since thicknesses of the light emitting devices 150 are usually very small, the shapes of the light emitting devices 150 may refer to shapes of longitudinal projections of the light emitting devices 150. Optionally, the shape of at least one light emitting device 150 of the plurality of light emitting devices 150 may be rectangular, circular, spherical and other shapes; and other shapes such as polygonal and abnormal shapes may also be set according to actual conditions such as process requirements.

In some embodiments, the display unit 200 may perform 3D display.

In some embodiments, different display units 200 may be spliced together. Optionally, a mode of splicing the different display units 200 together and the number of spliced display units 200 may be considered according to actual conditions such as process requirements. Optionally, there is a lining frame between two spliced display units 200.

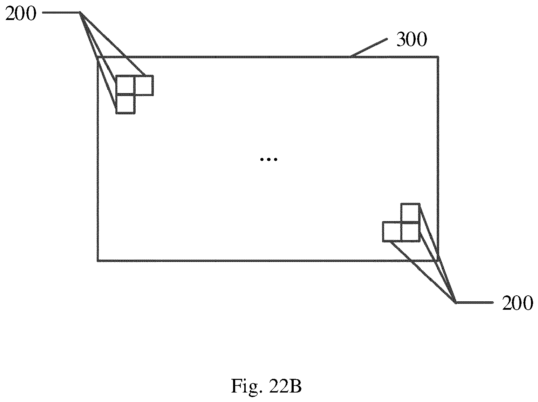

Referring to Figs. 22A and 22B, embodiments of the present disclosure provide a display 300, comprising the above display unit 200.

In some embodiments, the display 300 may perform 3D display.

In some embodiments, the display 300 may include at least one display unit 200; for example, the display 300 may include one, two, three or more display units 200. In the display 300 formed by the display units 200, there is a lining frame between the two spliced display units 200.

As shown in Fig. 22B, part or all of the plurality of display units 200 arranged in the display 300 may be arranged in array. In some embodiments, an array arrangement mode of the plurality of display units 200 may be a matrix, such as a row-and-column mode. In some embodiments, the array arrangement mode of the plurality of display units 200 may be different from that shown in Fig. 22B, but may be arrangement modes in other array shapes, such as circular, elliptical, triangular and other array arrangement modes.

In some embodiments, different display units 200 arranged in the display 300 may be spliced together. Optionally, a mode of splicing the different display units 200 together and the number of spliced display units 200 may be considered according to actual conditions such as process requirements. Optionally, there may be a lining frame between two spliced display units 200.

By the terminal connection structure, the display unit and the display provided by embodiments of the present disclosure, terminals for leading wires from light emitting devices may be arranged effectively even if a size of the light emitting device is very small.

The above description and drawings sufficiently illustrate the embodiments of the present disclosure to enable those skilled in the art to practice them. Other embodiments may include structural, logical, electrical, process, and other changes. The embodiments represent only possible changes. Unless expressly required, individual components and functions are optional and the order of operations may be changed. Parts and features of some embodiments may be included in or substituted for parts and features of other embodiments. The scope of the disclosed embodiments includes the full scope of the claims, and all available equivalents of the claims. When used in the present application, although the terms of "first", "second", etc. may be possibly used in the present application to describe various elements, these elements should not be limited by these terms. These terms are only used to distinguish one element from another. For example, without changing the meaning of the description, a first element may be called as a second element, and similarly, the second element may be called as the first element, as long as all of "the first elements" that appear are consistently renamed and all of "the second elements" that appear are consistently renamed. The first element and the second element are both elements, but may not be the same element. Moreover, the terms used in the present application are used to describe the embodiments only and not to limit the claims. As used in the illustration of the embodiments and the claims, unless clearly indicated in the context, the singular forms "a", "an" and "the" are also intended to include the plural forms. Similarly, the term "and/or" as used in the present application is meant to include any and all possible combinations of one or more of the associated listings. In addition, when used in the present application, the term "include" and its variations "includes" and/or "including", etc., refer to the presence of stated features, integers, steps, operations, elements, and/or components, but does not preclude the presence or addition of one or more other features, integers, steps, operations, elements, components and/or groupings of these. Without further limitations, an element limited by the phrase "includes a..." does not preclude the presence of additional identical elements in the process, method or device that includes the element. Herein, the difference of each embodiment from each other may be the focus of explanation. The same and similar parts among all of the embodiments may be referred to each other. For the method and product disclosed by the embodiments, if the method and product correspond to a method part disclosed by the embodiments, the description of the method part may be referred to for the related part.

Those skilled in the art may recognize that the units and algorithm steps of each example described in conjunction with the embodiments disclosed herein may be implemented in electronic hardware, or a combination of computer software and electronic hardware. Whether these functions are performed in hardware or software may depend on the specific application and design constraints of the technical solution. Those skilled in the art may use different methods for implementing the described functions for each particular application, but such implementations should not be considered beyond the scope of the embodiments of the present disclosure. Those skilled in the art may clearly understand that, for the convenience and brevity of description, the corresponding processes in the above method embodiments may be referred to for the specific working processes of the above systems, devices and units, which will not be repeated here.

In the embodiments disclosed herein, the disclosed method and product (including, but not limited to the apparatus and the device) may be realized in other ways. For example, the device embodiments described above are merely schematic. For example, the division of the units may be only a logical functional division, and may be an additional division manner in actual realization. For example, multiple units or components may be combined or integrated into another system, or some features may be ignored or not executed. In addition, the displayed or discussed mutual coupling or direct coupling or communication connection may be indirect coupling or communication connection through some interfaces, devices or units, and may be electrical, mechanical or other forms. The units described as separate components may or may not be physically separated, and the components shown as the units may or may not be physical units, that is, may be located in one place, or may be distributed on multiple network units. The present embodiments may be implemented by selecting some or all of the units according to actual needs. In addition, each functional unit in the embodiments of the present disclosure may be integrated into one processing unit, or each unit may exist physically alone, or two or more units may be integrated into one unit.

## Claims

1. A terminal connection structure, comprising: a plurality of terminals, a plurality of terminal-side conductive holes, an electrical connection layer, and a plurality of light emitting device-side conductive holes, wherein
the electrical connection layer is capable of being electrically connected with a plurality of light emitting devices through the plurality of light emitting device-side conductive holes, and electrically connected with the plurality of terminals through the plurality of terminal-side conductive holes;
the plurality of terminals are arranged in array;
the plurality of terminal-side conductive holes are arranged by region within a coverage range of the electrical connection layer; and terminal-side conductive holes arranged in at least one region have a same electric polarity.

2. The terminal connection structure according to claim 1, wherein the plurality of terminal-side conductive holes are divided into at least two regions; and terminal-side conductive holes arranged in a same region have a same electric polarity.

3. The terminal connection structure according to claim 2, wherein the plurality of terminal-side conductive holes are divided into three regions, comprising:
a Z-shaped first region, and
a second region and a third region, which are respectively located at two sides of the first region.

4. The terminal connection structure according to claim 3, wherein
terminal-side conductive holes arranged in the second region and the third region have a same electric polarity;
an electric polarity of terminal-side conductive holes arranged in the first region is different from an electric polarity of terminal-side conductive holes arranged in the second region and the third region.

5. The terminal connection structure according to claim 2, wherein the plurality of terminal-side conductive holes are divided into four regions in two rows and two columns, comprising:
a first region located in a first column of a first row,
a second region located in a second column of a first row,
a third region located in a first column of a second row, and
a fourth region located in a second column of a second row.

6. The terminal connection structure according to claim 5, wherein terminal-side conductive holes arranged in two adjacent regions of the four regions have different electric polarities.

7. The terminal connection structure according to claim 1, wherein part or all of terminal-side conductive holes in at least one region are arranged in array.

8. The terminal connection structure according to claim 1, wherein part or all of terminal-side conductive holes in at least one region are arranged at equal intervals.

9. The terminal connection structure according to claim 1, wherein all of terminal-side conductive holes arranged by region fall into part or all of a coverage range of the electrical connection layer.

10. The terminal connection structure according to any one of claims 1 to 9, wherein the electrical connection layer comprises at least two electrical connection layers; and the at least two electrical connection layers are capable of being electrically connected with a plurality of light emitting devices through the plurality of light emitting device-side conductive holes, and electrically connected with the plurality of terminals through the plurality of terminal-side conductive holes.

11. The terminal connection structure according to claim 10, wherein the at least two electrical connection layers comprise a light emitting device-side electrical connection layer and a terminal-side electrical connection layer; the plurality of light emitting device-side conductive holes comprise a plurality of first light emitting device conductive holes and second light emitting device conductive holes;
wherein the light emitting device-side electrical connection layer is capable of being electrically connected with the plurality of light emitting devices through the plurality of first light emitting device conductive holes;
the terminal-side electrical connection layer is capable of being electrically connected with the plurality of light emitting devices through the plurality of second light emitting device conductive holes.

12. The terminal connection structure according to claim 11, wherein at least one of the plurality of light emitting devices comprises a first electrode and a second electrode;
wherein the light emitting device-side electrical connection layer is capable of being electrically connected with the first electrode through at least one of the plurality of first light emitting device conductive holes;
the terminal-side electrical connection layer is capable of being electrically connected with the second electrode through at least one of the plurality of second light emitting device conductive holes.

13. The terminal connection structure according to claim 12, wherein each light emitting device of the plurality of light emitting devices comprises a first electrode and a second electrode;
wherein the light emitting device-side electrical connection layer is capable of being electrically connected with first electrodes of different light emitting devices in the plurality of light emitting devices respectively through the plurality of first light emitting device conductive holes;
the terminal-side electrical connection layer is capable of being electrically connected with second electrodes of different light emitting devices in the plurality of light emitting devices respectively through the plurality of second light emitting device conductive holes.

14. The terminal connection structure according to claim 11, wherein the terminal-side electrical connection layer and the light emitting device-side electrical connection layer are sequentially arranged from the plurality of terminals to the plurality of light emitting devices.

15. The terminal connection structure according to claim 14, further comprising at least one of following insulation layers:
an insulation layer for isolating the plurality of terminals from the terminal-side electrical connection layer;
an insulation layer for isolating the terminal-side electrical connection layer from the light emitting device-side electrical connection layer;
an insulation layer for isolating the light emitting device-side electrical connection layer from the plurality of light emitting devices.

16. The terminal connection structure according to any one of claims 11 to 15, wherein the plurality of terminal-side conductive holes comprise a plurality of first terminal conductive holes and a plurality of second terminal conductive holes;
wherein the light emitting device-side electrical connection layer is electrically connected with the plurality of terminals through the plurality of first terminal conductive holes;
the terminal-side electrical connection layer is electrically connected with the plurality of terminals through the plurality of second terminal conductive holes.

17. The terminal connection structure according to claim 16, wherein the plurality of terminals comprise at least one first terminal and at least one second terminal;
wherein the light emitting device-side electrical connection layer is electrically connected with the at least one first terminal through at least one of the plurality of first terminal conductive holes;
the terminal-side electrical connection layer is electrically connected with the at least one second terminal through at least one of the plurality of second terminal conductive holes.

18. The terminal connection structure according to claim 17, wherein the at least one first terminal comprises a plurality of first terminals, and the at least one second terminal comprises a plurality of second terminals;
wherein the light emitting device-side electrical connection layer is electrically connected with the plurality of first terminals through the plurality of first terminal conductive holes respectively;
the terminal-side electrical connection layer is electrically connected with the plurality of second terminals through the plurality of second terminal conductive holes respectively.

19. The terminal connection structure according to claim 16, wherein the terminal-side conductive holes arranged in a same region are:
the plurality of first terminal conductive holes, or
the plurality of second terminal conductive holes.

20. The terminal connection structure according to any one of claims 16 to 19, wherein at least one of the light emitting device-side electrical connection layer and the terminal-side electrical connection layer is arranged in following modes:
the light emitting device-side electrical connection layer comprises at least one layer of light emitting device-side conductive lines;
the terminal-side electrical connection layer comprises at least one layer of terminal-side conductive lines.

21. The terminal connection structure according to claim 20, wherein a plurality of terminal-side conductive holes having a same electric polarity in all regions are electrically connected with a plurality of lines in a same electrical connection layer respectively.

22. The terminal connection structure according to claim 21, wherein all terminal-side conductive holes having a same electric polarity in all regions are electrically connected with all lines in a same electrical connection layer respectively.

23. The terminal connection structure according to claim 20, wherein the at least one layer of light emitting device-side conductive lines comprises a plurality of light emitting device-side conductive lines electrically connected with the plurality of first terminal conductive holes respectively; and the terminal-side conductive holes arranged in a same region are the plurality of first terminal conductive holes, wherein
a plurality of first terminal conductive holes electrically connected with a plurality of adjacent light emitting device-side conductive lines respectively are in linear arrangement; or
a plurality of first terminal conductive holes electrically connected with a plurality of spaced light emitting device-side conductive lines respectively are in linear arrangement; or
a plurality of first terminal conductive holes electrically connected with a plurality of adjacent light emitting device-side conductive lines respectively, and a plurality of first terminal conductive holes electrically connected with a plurality of spaced light emitting device-side conductive lines respectively are in linear arrangement.

24. The terminal connection structure according to claim 23, wherein one light emitting device-side conductive line is electrically connected with at least one first terminal conductive hole in the plurality of light emitting device-side conductive lines and a plurality of first terminal conductive holes.

25. The terminal connection structure according to claim 20, wherein the at least one layer of terminal-side conductive lines comprises a plurality of terminal-side conductive lines electrically connected with the plurality of second terminal conductive holes respectively; and the terminal-side conductive holes arranged in a same region are the plurality of second terminal conductive holes, wherein
a plurality of second terminal conductive holes electrically connected with a plurality of adjacent terminal-side conductive lines respectively are in linear arrangement; or
a plurality of second terminal conductive holes electrically connected with a plurality of spaced terminal-side conductive lines are in linear arrangement; or
a plurality of second terminal conductive holes electrically connected with a plurality of adjacent terminal-side conductive lines, and a plurality of second terminal conductive holes electrically connected with a plurality of spaced terminal-side conductive lines are in linear arrangement.

26. The terminal connection structure according to claim 25, wherein one terminal-side conductive line is electrically connected with at least one second terminal conductive hole in the plurality of terminal-side conductive lines and a plurality of second terminal conductive holes.

27. The terminal connection structure according to any one of claims 23 to 26, wherein the linear arrangement comprises oblique line arrangement.

28. The terminal connection structure according to any one of claims 23 to 26, wherein the linear arrangement comprises at least one of straight line arrangement and curved line arrangement.

29. The terminal connection structure according to any one of claims 23 to 26, wherein the linear arrangement comprises linear arrangement of at least one line.

30. The terminal connection structure according to claim 20, wherein at least one of the light emitting device-side conductive lines and the terminal-side conductive lines is arranged in array.

31. The terminal connection structure according to claim 30, wherein at least one of the light emitting device-side conductive lines and the terminal-side conductive lines is arranged in array in a form of rows or columns.

32. The terminal connection structure according to claim 31, wherein
the light emitting device-side conductive lines are arranged in array in a form of rows, and the terminal-side conductive lines are arranged in array in a form of columns; or,
the light emitting device-side conductive lines are arranged in array in a form of columns, and the terminal-side conductive lines are arranged in array in a form of rows.

33. The terminal connection structure according to claim 20, wherein
each line of the terminal-side conductive lines is electrically connected with at least one terminal of the plurality of terminals, or
each line of the light emitting device-side conductive lines is electrically connected with at least one terminal of the plurality of terminals.

34. The terminal connection structure according to claim 1, wherein at least one terminal of the plurality of terminals covers at least one terminal-side conductive hole of the plurality of terminal-side conductive holes.

35. The terminal connection structure according to claim 1, wherein part or all terminals of the plurality of terminals are arranged at equal intervals.

36. The terminal connection structure according to claim 1, wherein
part of the plurality of terminals are arranged in array; or,
all of the plurality of terminals are arranged in array.

37. A display unit, comprising a plurality of light emitting devices and the terminal connection structure of any one of claims 1 to 36.

38. The display unit according to claim 37, wherein the plurality of light emitting devices comprise at least one light emitting diode (LED) light emitting device.

39. The display unit according to claim 38, wherein the at least one LED light emitting device comprises at least one Micro LED light emitting device.

40. The display unit according to any one of claims 37 to 39, wherein the plurality of light emitting devices are arranged in array.

41. The display unit according to claim 40, wherein
part of the plurality of light emitting devices are arranged in array; or,
all of the plurality of light emitting devices are arranged in array.

42. A display, comprising the display unit of any one of claims 37 to 41.
